# EUROPÄISCHE PATENTSCHRIFT

(11) **EP 2 835 838 B1**
(45) Veröffentlichungstag und Bekanntmachung des Hinweises auf die Patenterteilung: **15.02.2017**
(21) Anmeldenummer: 13179696.3
(22) Anmeldetag: 08.08.2013
(51) Int. Cl.: H01L 39/02

(54) **Hochtemperatur-Supraleiter-Bandleitersystem**
High temperature tape superconductor system
Système de bande supraconductrice à haute température

(43) Veröffentlichungstag der Anmeldung: 11.02.2015
(73) Patentinhaber: Theva Dünnschichttechnik GmbH, 85737 Ismaning (DE)
(72) Erfinder: Prusseit, Werner, 80799 München (DE)
(74) Vertreter: Wegner, Hans

(56) Entgegenhaltungen:
- EP-A1- 2 131 408
- WO-A2-2005/079220
- JP-A- 2001 319 750
- US-A1- 2012 065 074
- US-B1- 7 071 148

## Beschreibung

### 1. Technisches Gebiet

Die vorliegende Erfindung betrifft ein Hochtemperatur-Supraleiter-Bandleitersystem und ein Verfahren zu dessen Herstellung.

### 2. Stand der Technik

Im Folgenden wird als Hochtemperatur-Supraleiter-Bandleiter (HTS-Bandleiter) oder auch nur Bandleiter eine supraleitende Leiterkonfiguration bezeichnet, die auf einem flexiblen Metallsubstrat bzw. einer flexiblen Metallsubstratfolie basiert, auf das auf einer oder mehreren Zwischenschichten mindestens eine HTS-Schicht als supraleitende, stromführende Funktionsschicht aufgebracht wird. Die eine oder die mehreren Zwischenschichten - auch als Pufferschichten bezeichnet - können beispielsweise als Diffusionsbarriere wirken oder eine kristalline Orientierung bereitstellen und als Epitaxieunterlage für die HTS-Schicht dienen.

HTS-Bandleiter stellen in der Elektro- und Energietechnik ein Standardleitermaterial dar, aus dem Leitungen, Kabel oder Windungen und Spulen hergestellt werden. HTS-Bandleiter ersetzen in diesen Anwendungen Kupferdraht, da sie vielfach höhere elektrische Ströme transportieren können. Diese hohen Ströme würden im Kupfer zu hohen ohmschen Verlusten führen. Mit dem Einsatz von Supraleitern können diese Verluste verringert und eine erheblich kompaktere Bauweise realisiert werden.

Weiterhin können auch Komponenten, bei denen bereits heute metallische Supraleiter statt Kupferleiter eingesetzt werden, z.B. Magnetresonanztomographen oder starke Elektromagnete, verbessert werden. Hochtemperatur-Supraleiter erlauben eine deutlich höhere Betriebstemperatur und halten höheren Magnetfeldern stand. Zudem führt die resultierende Verringerung des Kühlaufwandes zu einem einfacheren Aufbau und einer Verbesserung des Wirkungsgrades.

In den meisten dieser Anwendungen werden möglichst lange, defektfreie HTS-Bandleiterstücke benötigt. Da die Länge von HTS-Bandleitern herstellungsbedingt begrenzt ist, müssen einzelne HTS-Bandleiter miteinander verbunden werden, ohne dass an den Verbindungsstellen Qualitätseinbußen (beispielsweise eine geringere Stromtragfähigkeit und/oder geänderte mechanische Eigenschaften) auftreten. In Folgenden bezeichnet ein HTS-Bandleitersystem eine Verbindung von zwei oder mehreren HTS-Bandleitern zu einem HTS-Bandleiter.

Die Herstellung von HTS-Bandleitern erfolgt durch kontinuierliche, physikalische oder chemische Beschichtungsverfahren von Rolle zu Rolle. Das Bandsubstrat wird dabei von einer Vorratsrolle abgespult, durch Beschichtungs- und Prozesszonen geführt und auf der anderen Seite wieder auf eine Vorratsspule aufgewickelt. Das Herstellen großer Stücklängen von einigen hundert Metern oder gar über einem Kilometer erfordert lange Prozesszeiten. Treten während dieser Zeit Parameterschwankungen in den Prozessen oder lokale Störungen z.B. durch Verschmutzungen, Kratzer in dem Metallsubstrat, etc. auf, so äußern sich diese durch lokale Defekte in der HTS-Beschichtung, an denen die supraleitende Stromtragfähigkeit reduziert ist. Diese Schwachstellen limitieren in der Anwendung die gesamte Leistungsfähigkeit des HTS-Bandleiters und haben damit drastischen Einfluss auf den Wert das Bandleiters. Bei starken Qualitätseinbrüchen werden die Bereiche geringer supraleitender Stromtragfähigkeit herausgeschnitten bzw. die HTS-Bandleiter werden in kürzere Segmente gewünschter Qualität zerschnitten.

Ferner sind die prozessierbaren Stücklängen beim oben beschriebenen Verfahren naturgemäß durch die Größe der Vorratsspulen und die längst mögliche Prozesszeit begrenzt. Da es bei Beschichtungsprozessen Prinzip-bedingt zur Verschmutzung der Anlagenkomponenten kommt, müssen diese in regelmäßigen Intervallen gereinigt und gewartet werden, was die maximale Prozesszeit bestimmt.

Um die geforderten Längen zu erreichen, müssen deshalb mehrere HTS-Bandleiter zu einem HTS-Bandleitersystem verbunden bzw. gespleißt werden. Dabei ist die Verbindung der einzelnen HTS-Bandleiter so auszuführen, dass es im Bereich der Verbindungsstelle im Wesentlichen zu keinem Qualitätseinbruch kommt.

Bei Hochtemperatur-Supraleitern handelt es sich um komplexe Metalloxide, die zudem nahezu einkristallin vorliegen müssen, um hohe Stromtragfähigkeiten >10⁶ A/cm² zu ermöglichen. Kratzer oder sonstige Defekte im Substratband oder an Verbindungsstellen des Substratbandes können dazu führen, dass in diesen Bereichen das Substrat nicht epitaktisch überwachsen werden kann, d.h. auf diesen Bereich kann keine HTS-Schicht aufgebracht werden. Bis dato gibt es kein praktikables Verfahren Störstellen im Substratband durch Supraleiterschichten mit vergleichbar hoher Stromtragfähigkeit zu überbrücken. Zudem gibt es keine derzeit Verbindungstechnik bei eine HTS-Schicht direkt mit einer HTS-Schicht supraleitend verbunden werden kann. Alle gängigen Verbindungstechniken benutzen deshalb möglichst niederohmige Kontakte, um eine elektrische Verbindung zwischen zwei Supraleiterstücken oder zwischen zwei HTS-Bandleitern in einem HTS-Bandleitersystem herzustellen. Auch wenn damit streng genommen kein supraleitender, i.e. widerstandsfreier Strom zwischen den HTS-Bandleitern oder innerhalb des HTS-Bandleitersystems fließen kann, so ist es doch möglich, die elektrischen Verluste durch großflächige Kontakte mit niedrigen Kontaktwiderständen in einem vertretbaren Bereich < 10⁻⁷ Ω zu halten.

Eine typische Verbindungstechnik, die beispielsweise in der Patentschrift EP 1198 846 B1 beschrieben ist, ist die Verbindung über eine leitfähige Kontaktschicht (face-to-face) durch Aufeinanderlaminieren (Löten) von zwei HTS-Bandleitern. Wie in der US 2009 / 0 298 696 A1 dargestellt, kann die Verbindungsstelle zudem im Randbereich zusätzlich versiegelt werden. Darüber hinaus offenbart die Patentschrift US 7 071148 B1 das Verbinden zweier HTS-Bandleiterstücke durch das Aufsetzen eines dritten HTS-Bandleiters als Überbrückung. Dies stellt im Grunde nur eine doppelte Bandverbindung der obigen Art dar. Wie in der WO 2012 / 128 954 A1 angegeben, ist auch eine Reparatur durch eine lokale Überbrückung von Bereichen mit geringer supraleitendender Stromtragfähigkeit auf diese Weise möglich.

Eine weitere Option HTS-Bandleitersysteme aus HTS-Bandleitern herzustellen, besteht darin, deren Substrate oder Metallsubstrate, also deren Rückseiten (back-to-back) mechanisch zu verbinden und den elektrischen Kontakt durch eine einhüllende Kontaktschicht oder Klammer herzustellen. Die Patentschrift US 7 774 035 B2 und die Anmeldung US 2006 / 0 073 979 A1 beschreiben solche Konfigurationen. Ferner können, wie in der US 9 195 260 B2 ausgeführt, auch ganze HTS-Bandleiterbündel in ähnlicher Weise zusammengefasst und verbunden werden.

Die HTS-Bandleitersysteme nach dem Stand der Technik weisen einige gravierende technische Nachteile auf. In den meisten Fällen stellt die elektrische Verbindung, z.B. durch Löten, auch die mechanische Verbindung dar. Die mechanische Belastbarkeit des Kontakts oder der Verbindungsstelle der beiden HTS-Bandleiter ist deshalb im Allgemeinen wesentlich geringer als die eines intakten Bandleiters, die durch das Substrat oder Metallsubstrat gegeben ist.

Noch gravierender ist jedoch, dass im Bereich der Verbindung oder des Spleißes der beiden HTS-Bandleiter die Dicke des HTS-Bandleitersystem praktisch doppelt so groß wie im normalen HTS-Bandleiter ist. Überdies ist auch die Flexibilität im Verbindungsbereich stark eingeschränkt. Dies kann zu verarbeitungstechnischen Problemen führen. So lässt sich eine derart verdickte Stelle nicht genauso wickeln wie ein HTS-Bandleiter und im Spulenwickel, z.B. auf den Vorratsspulen oder beim Bau von Magnetspulen, oder an Überkreuzungen von HTS-Bandleitern entstehen Hohlräume und Druckstellen. Durch das Eindrücken der verdickten Stelle in darüber liegende Lagen des HTS-Bandleiters kann in diesen die Supraleiterschicht beschädigt werden; da beim Unterschreiten eines kritischen Krümmungsradius im HTS-Bandleiter die HTS-Schicht reißt.

Um diese Verdickung möglichst zu vermeiden, beschreibt z.B. die US 7 071 148 B1, dass es zumindest für einen HTS-Bandleiter mit einer dicken Stabilisierungsschicht möglich ist, die Enden der Stabilisierungsschicht vor dem Verbinden so zu dünnen, so dass die Gesamtdicke der Verbindungsstelle nicht mehr als die 1,8-fache HTS-Bandleiterdicke beträgt. Dieses Verfahren kann jedoch nur zur Herstellung von HTS-Bandleitersystemen angewendet werden, deren HTS-Bandleiter tatsächlich eine Stabilisierungsschicht aufweisen.

Darüber hinaus offenbart die Patentschrift US 7 071 148 B1 einen supraleitenden Gegenstand, der ein erstes supraleitendes Segment mit einer nominalen Dicke tₙ₁ aufweist, ein zweites supraleitendes Segment mit einer nominalen Dicke tₙ₂ aufweist und einen Verbindungsbereich, der einen Spleiß umfasst, der das erste und das zweite supraleitende Segment miteinander verbindet. Der Spleiß überlappt Teile sowohl des ersten als auch des zweiten supraleitenden Segments längs des Verbindungsbereichs, wobei der Verbindungsbereich eine Dicke tⱼᵣ aufweist die nicht größer als zumindest eines von 1,8 tₙ₁ und 1,8 tₙ₂ ist.

Die US 2012 / 0 065 074 A1 einen supraleitenden Gegenstand, der erste und zweite geschichtete supraleitende Segmente einschließt. Das erste geschichtete Leitersegment umfasst erste und zweite supraleitende Segmente und weist eine nominale Dicke tₙ₁ auf. Das zweite geschichtete Leitersegment umfasst dritte und vierte supraleitende Segmente und weist eine nominale Dicke tₙ₂ auf. Der supraleitende Gegenstand umfasst ferner einen Verbindungsbereich, der einen ersten Spleiß umfasst, der das erste und das dritte supraleitende Segment miteinander verbindet und umfasst einen zweiten Spleiß, der das zweite und das vierte supraleitende Segment miteinander verbindet. Der erste Spleiß ist angrenzend an und überbrückt das erste und das dritte supraleitende Segment längs zumindest eines Teils des Verbindungsbereichs und zweite Spleiß ist angrenzend an und überbrückt das zweite und das vierte supraleitende Segment längs zumindest eines Teils des Verbindungsbereichs. Der Verbindungsbereich weist eine Dicke tⱼᵣ auf, wobei tⱼᵣ nicht größer als zumindest eines von 1,8 tₙ₁ und 1,8 tₙ₂ ist.

Die EP 2 131 408 A1 bezieht sich auf einen Prozess zum Vorbereiten eines geformten Substrats, das für die Produktion eines beschichteten Leiters geeignet ist, wobei der Prozess die Deformation eines texturierten Substrats erlaubt, auf das bereits eine tekturierte Puffer-Schicht aufgewachsen worden ist.

Die WO 2005 / 079 220 A2 offenbart ein tragbares System zum Verbinden zweier Supraleiterstücke. Das tragbare System umfasst eine Unterlage, die zum Halten der beiden benachbarten Supraleiterstücke in einer Reaktionsfläche angeordnet ist, einen Verteilerkopf zum Abscheiden zumindest eines Materials auf die Reaktionsfläche, das zum Verbinden der zwei Supraleiterstücke benutzt wird, eine Ionenquelle, die zum Bestrahlen der Reaktionsfläche mit Ionen angeordnet ist, einen Gasanschluss, um dem System zumindest ein Gas bereitzustellen, und einen Vakuumanschluss, der angeordnet ist, um einen gewünschten atmosphärischen Druck in dem System herzustellen.

Die JP 2001-319750 offenbart ein Verbindungsverfahren für oxidische Supraleiter. An den Enden der Supraleiter wird die Supraleiterschicht von dem Basismaterial entfernt und dann werden die Basismaterialien der beiden Supraleiter an deren Stirnflächen zum Verbinden in Kontakt gebracht. Sodann wird eine supraleitende Schicht auf den Verbindungsbereich der Basismaterialien abgeschieden, um die beiden supraleitenden Schichten der beiden Supraleiter miteinander zu verbinden. Auf der Oberfläche der supraleitenden Verbindungsschicht wird eine Schutzschicht abgeschieden.

Der vorliegenden Erfindung liegt daher das Problem zu Grunde, ein HTS-Bandleitersystem anzugeben, dessen mechanische und elektrische Eigenschaften denen eines HTS-Bandleiters möglichst nahekommen und die die oben beschriebenen Nachteile zumindest zum Teil vermeiden.

### 3. Zusammenfassung der Erfindung

Gemäß einem Ausführungsbeispiel der vorliegenden Erfindung wird dieses Problem durch ein Hochtemperatur-Supraleiter-Bandleitersystem nach Anspruch 1 gelöst. In einer Ausführungsform weist das Hochtemperatur-Supraleiter-Bandleitersystem auf: (a) einen ersten Hochtemperatur-Supraleiter-Bandleiter mit einem ersten Metallsubstrat und einer ersten Supraleiterschicht; (b) einen zweiten Hochtemperatur-Supraleiter-Bandleiter mit einem zweiten Metallsubstrat und einer zweiten Supraleiterschicht; und (c) einen Metallsubstratverbindungsbereich, in dem das erste und das zweite Metallsubstrat im Wesentlichen auf Stoß miteinander verbunden sind.

Ein erfindungsgemäßes HTS-Bandleitersystem entkoppelt die mechanische Verbindung von HTS-Bandleitern von deren elektrischer Verbindung. Damit können die beiden Verbindungen im Wesentlichen unabhängig voneinander optimiert werden. Die mechanische Verbindung geschieht vorzugsweise über das Zusammenschweißen der Metallsubstrate an der Stoßstelle. Diese Verbindung kann ohne deutliche lokale Verdickung des HTS-Bandleitersystems realisiert werden und stellt im Wesentlichen keine mechanische Schwachstelle dar, da sie eine Verbindung erzeugt, deren mechanische Belastbarkeit grundsätzlich vergleichbar ist mit dem Metallsubstrat eines HTS-Bandleiters. In einem erfindungsgemäßen HTS-Bandleitersystem muss die elektrische Verbindung zwischen den HTS-Bandleitern allenfalls geringe Kräfte aufnehmen. Dadurch kann diese Verbindung durch eine sehr dünne supraleitende Überbrückung realisiert werden.

In einem HTS-Bandleitersystem können die erste und die zweite Supraleiterschicht im Wesentlichen die gleiche Zusammensetzung aufweisen. Ferner können das erste Metallsubstrat und das zweite Metallsubstrat ebenfalls im Wesentlichen gleich sein. Es ist jedoch auch möglich, dass in dem HTS-Bandleitersystem HTS-Schichten mit verschiedenen Materialzusammensetzungen zu kombinieren. Zudem ist es möglich, dass in einem HTS-Bandleitersystem HTS-Bandleiter mit verschiedenen Metallsubstraten verbunden werden.

Der Begriff "im Wesentlichen" bedeutet hier wie an anderen Stellen dieser Beschreibung, die Angabe einer Größe innerhalb üblicher Herstellungstoleranzen.

In einem weiteren Aspekt weist der Metallsubstratverbindungsbereich eine Dicke auf von weniger als 1,5 der mittleren Dicke des ersten und des zweiten Metallsubstrats, bevorzugt weniger als 1,3 der mittleren Dicke des ersten und des zweiten Metallsubstrats, mehr bevorzugt weniger als 1,2 der mittleren Dicke des ersten und des zweiten Metallsubstrats, und am meisten bevorzugt weniger als 1,1 der mittleren Dicke des ersten und des zweiten Metallsubstrats.

Gemäß einem anderen Aspekt ist der Metallverbindungsbereich ausgebildet, um einer Zugspannung von mehr als 50 %, bevorzugt mehr als 60 %, mehr bevorzugt mehr als 70 %, und am meisten bevorzugt mehr als 80 % der Zugspannung zu widerstehen, der das erste oder das zweite Metallsubstrat ohne wesentliche Beschädigung zu widerstehen.

Nach einem weiteren Aspekt weist ein Verbindungsstück zum Herstellen einer supraleitenden Verbindung zwischen der ersten Supraleiterschicht und der zweiten Supraleiterschicht auf: (a) zumindest eine Pufferschicht; (b) eine erste Kontaktschicht, die auf einer ersten Seite der Pufferschicht angeordnet ist; (c) eine Supraleiterschicht, die auf einer zweiten Seite der Pufferschicht angeordnet ist; und (d) eine zweite Kontaktschicht, die auf der Supraleiterschicht angeordnet ist.

Das definierte supraleitende Verbindungsstück ist unabhängig von einem erfindungsgemäßen HTS-Bandleitersystem. Es ist nicht notwendig, dass ein dünnes supraleitendes Verbindungsstück in einem erfindungsgemäßen HTS-Bandleitersystem eingesetzt wird. Andererseits kann das definierte supraleitende Verbindungsstück unabhängig vom Herstellen eines HTS-Bandleitersystem auch zum Reparieren eines Bereichs gestörter Supraleitung in einem HTS-Bandleiter eingesetzt werden.

Sehr dünne supraleitende Verbindungsstücke lassen sich aus praktisch freistehenden HTS-Schichten realisieren. Damit lassen sich Verbindungsstellen und Reparaturstellen realisieren, deren Dicke um weniger als 20 % größer als die Dicke der verbundenen HTS-Bandleiter bzw. des reparierten HTS-Bandleiters ist.

In einem weiteren Aspekt weist ein Verfahren zum Herstellen eines Hochtemperatur-Supraleiter-Bandleitersystems die Schritte auf: (a) Ausrichten eines ersten Hochtemperatur-Supraleiter-Bandleiters mit einem ersten Metallsubstrat und einer ersten Supraleiterschicht und eines zweiten Hochtemperatur-Supraleiter-Bandleiters mit einem zweiten Metallsubstrat und einer zweiten Supraleiterschicht im Wesentlichen auf Stoß; und (b) Verbinden des ersten und des zweiten Metallsubstrats in einem Metallsubstratverbindungsbereich, in dem das erste und das zweite Metallsubstrat im Wesentlichen auf Stoß miteinander verbunden sind.

Der Schritt des Ausrichtens der beiden zu verbindenden HTS-Bandleiter erfolgt dergestalt, dass das erste Metallsubstrat und das zweite Metallsubstrat einen seitlichen Versatz aufweisen von vorzugsweise weniger als 5 % der mittleren Breite des ersten und des zweiten Metallsubstrats oder einen seitlichen Versatz von weniger als 5 mm.

Ferner führt das Ausrichten der Metallsubstrate der beiden HTS-Bandleiter zu einem Höhenversatz von vorzugsweise weniger als 30 % der mittleren Dicke des ersten und des zweiten Metallsubstrats, bevorzugt weniger als 20 % der mittleren Dicke des ersten und des zweiten Metallsubstrats, mehr bevorzugt weniger als 10 % der mittleren Dicke des ersten und des zweiten Metallsubstrats und am meisten bevorzugt weniger als 5 % der mittleren Dicke des ersten und des zweiten Metallsubstrats.

Darüber hinaus führt das präzise Ausrichten der Metallsubstrate der beiden HTS-Bandleiter dazu, dass das HTS-Bandleitersystem relativ zu einem einzelnen HTS-Bandleiter eine Winkelabweichung von weniger als 5°, bevorzugt weniger als 2°, und am meisten bevorzugt weniger als 1° aufweist. Schließlich wird durch das genaue Ausrichten der Metallsubstrate der beiden HTS-Bandleiter zueinander eine Verdrehung der beiden Metallsubstrate im HTS-Bandleitersystem in Längsrichtung von weniger als 2°, und bevorzugt weniger als 1° erreicht.

Gemäß einem weiteren Aspekt umfasst das Verbinden des ersten und des zweiten Metallsubstrats das Schweißen auf Stumpfstoß des ersten und des zweiten Metallsubstrats.

In einem vorteilhaften Aspekt weist weder der erste Hochtemperatur-Supraleiter-Bandleiter noch der zweite Hochtemperatur-Supraleiter-Bandleiter eine Stabilisierungsschicht auf.

Ein erfindungsgemäßes Verfahren wird bevorzugt mit nicht konfektionierten HTS-Bandleitern ausgeführt. Dies hat den Vorteil, dass HTS-Bandleitersysteme mit Verbindungsstellen bzw. Reparaturstellen von HTS-Bandleitern deren Dicke gegenüber einem ursprünglichen HTS-Bandleiter nur unwesentlich geändert ist, hergestellt werden können. Ferner weist das Herstellen eines HTS-Bandleitersystems aus nicht konfektionierten HTS-Bandleitern bzw. das Reparieren nicht konfektionierter HTS-Bandleiter prozesstechnische Vorteile auf.

Ein weiterer Aspekt weist ferner den Schritt auf: Anbringen eines supraleitenden Verbindungsstücks auf die erste Supraleiterschicht und die zweite Supraleiterschicht.

Es ist vorteilhaft, auf die erste Supraleiterschicht des ersten HTS-Bandleiters und die zweite Supraleiterschicht des zweiten HTS-Bandleiters eine dünne Kontaktschicht aufzubringen. Diese weist bevorzugt eines oder mehrere Edelmetalle auf. Eine Kontaktschicht erleichtert das Anbringen eines supraleitenden Verbindungsstücks auf der ersten und der zweiten Supraleiterschicht wesentlich.

In einem besonders günstigen Aspekt umfasst das Herstellen des supraleitenden Verbindungsstücks die Schritte: (a) Schneiden eines Hochtemperatur-Supraleiter-Bandleiters auf eine vorgegebene Länge, wobei der Hochtemperatur-Supraleiter-Bandleiter umfasst: ein Metallsubstrat, zumindest eine Pufferschicht, die auf dem Metallsubstrat angeordnet ist, und eine Supraleiterschicht, die auf der zumindest einen Pufferschicht angeordnet ist; und (b) Ablösen eines Metallsubstrats von dem Hochtemperatur-Supraleiter-Bandleiter.

Bevorzugt weist die Supraleiterschicht des Verbindungsstücks eine Kontaktschicht auf. Die Supraleiterschicht des Verbindungsstücks kann die Materialzusammensetzung der ersten oder der zweiten Supraleiterschicht des ersten bzw. des zweiten HTS-Bandleiters aufweisen. Dies ist vorteilhaft, da das supraleitende Verbindungsstück aus einem der beiden HTS-Bandleiter hergestellt werden kann. Es ist jedoch auch möglich, ein supraleitendes Verbindungsstück herzustellen und anzuwenden, dessen supraleitende Schicht eine andere Zusammensetzung als die erste und/oder die zweite Supraleiterschicht des ersten bzw. des zweiten HTS-Bandleiters aufweist. Ferner kann die Dicke der HTS-Schicht des supraleitenden Verbindungsstücks von der Dicke der ersten Supraleiterschicht und der zweiten Supraleiterschicht abweichen.

Gemäß einem weiteren Aspekt umfasst das Ablösen des Metallsubstrats: (a) Ändern der chemischen Zusammensetzung der zumindest einen Pufferschicht; und (b) Abheben der geänderten Pufferschicht und der Supraleiterschicht von dem Metallsubstrat.

Das definierte Verfahren zum Herstellen eines supraleitenden Verbindungsstücks kann unabhängig vom erfindungsgemäßen Verfahren zum Herstellen eines HTS-Bandleitersystems eingesetzt werden. D.h., es ist nicht notwendig, dass supraleitende Verbindungsstücke im Rahmen des Herstellens eines HTS-Bandleitersystems erzeugt werden. Noch ist es notwendig, supraleitende Verbindungsstücke ausschließlich zum Herstellen eines HTS-Bandleitersystems Verwendung finden. Vielmehr können supraleitende Verbindungsstücke unabhängig von einem HTS-Bandleitersystem hergestellt werden. Darüber hinaus können supraleitende Verbindungsstücke unabhängig von einem HTS-Bandleitersystem zum Reparieren von Bereichen gestörter Supraleitung in einem HTS-Bandleiter eingesetzt werden.

Wie bereits oben ausgeführt, lassen sich sehr dünne supraleitende Verbindungsstücke (mit eine Dicke < 10 µm) aus praktisch freistehenden HTS-Schichten realisieren. Diese weisen nur eine oder mehrere dünne Pufferschichten (< 5 µm) und ebenfalls sehr dünne Kontaktschichten (< 2 µm) auf. Damit lassen sich Verbindungsstellen bzw. Reparaturstellen realisieren, deren Dicke um weniger als 20 % größer als die Dicke der in einem HTS-Bandleitersystem verbundenen HTS-Bandleiter bzw. des reparierten HTS-Bandleiters ist.

Das Ablösen eines supraleitenden Verbindungsstücks - das im Folgenden auch als HTS-Patch bezeichnet wird - von dem Metallsubstrat erfolgt bevorzugt mit Hilfe einer Klebefolie, die auf die Supraleiterschicht bzw. die Kontaktschicht des Verbindungsstücks aufgebracht wird. Die Folie dient ferner zum Transport des Verbindungsstücks an die Verbindungs- bzw. Reparaturstelle.

Nach noch einem anderen Aspekt weist der Schritt c. ferner auf: Auslagern des Hochtemperatur-Supraleiter-Bandleiters bei einer Temperatur größer als 600° C in Sauerstoff und/oder in Luft für eine vorgegebene Zeitdauer, bevorzugt für mehr als 30 Minuten.

Ein weiterer vorteilhafter Aspekt weist den Schritt auf: Anbringen einer Kontaktschicht auf eine von der Supraleiterschicht abgewandte Seite der Pufferschicht.

Noch ein anderer günstiger Aspekt weist den Schritt auf: Aufbringen einer durchgängigen Stabilisierungsschicht auf die erste Supraleiterschicht, das supraleitende Verbindungsstück und die zweite Supraleiterschicht.

Das nachträgliche (d.h. nach einer Reparatur eines HTS-Bandleiters oder dem Herstellen eines HTS-Bandleitersystems) Aufbringen einer durchgängigen Stabilisierungsschicht steht in keinem direkten Zusammenhang mit dem Herstellen eines HTS-Bandleitersystems oder der Reparatur eines HTS-Bandleiters. Vielmehr kann dieser Aspekt losgelöst vom Herstellen eines HTS-Bandleitersystem an einem reparierten HTS-Bandleiter ausgeführt werden.

Schließlich weist noch ein weiterer Aspekt den Schritt auf: Aufbringen einer durchgängigen Stabilisierungsschicht auf das erste Metallsubstrat, den Metallsubstratverbindungsbereich und das zweite Metallsubstrat. Darüber hinaus ist es auch möglich, ein HTS-Bandleitersystem oder einen HTS-Bandleiter vollflächig mit einer Stabilisierungsschicht zu umhüllen.

### 4. Beschreibung der Zeichnungen

In der folgenden detaillierten Beschreibung werden bevorzugte Ausführungsbeispiele der Erfindung unter Bezugnahme auf die Zeichnungen beschrieben, wobei
- Fig. 1: schematisch einen prinzipiellen Aufbau (im Querschnitt) eines nicht konfektionierten Hochtemperatur-Supraleiter (HTS)-Bandleiters ohne Stabilisierungs- und Isolierungsschicht zeigt;
- Fig. 2: schematisch einen Längsschnitt durch eine Verbindungstelle bzw. den Metallsubstratverbindungsbereich zweier HTS-Bandleiter nach Verschweißung der Metallsubstrate an einer Stoßstelle darstellt;
- Fig. 3: schematisch einen Querschnitt durch einen HTS-Bandleiter mit einer Opferschicht angibt;
- Fig. 4: eine Elektronenmikroskopische Aufnahme des Querschnitts eines HTS-Bandleiters im Kontaktbereich zum Metallsubstrat nach dem Ändern der chemischen Zusammensetzung einer Pufferschicht wiedergibt;
- Fig. 5: einen schematischen Querschnitt durch ein supraleitendes Verbindungsstück nach Ablösung vom Metallsubstrat repräsentiert;
- Fig. 6: das supraleitende Verbindungsstück der Fig. 5 nach Aufbringen einer Kontaktschicht zeigt;
- Fig. 7: einen HTS-Bandleiter mit einem gestörten Supraleiterbereich darstellt, der mit einer in der Fig. 6 dargestellten supraleitenden Verbindungsstück überbrückt wurde;
- Fig. 8: einen schematischen Querschnitt durch ein HTS-Bandleitersystem repräsentiert mit einem geschweißten Metallsubstratverbindungsbereich und einem supraleitenden Verbindungsstück, das eine erste Supraleiterschicht eines ersten HTS-Bandleiters mit einer zweiten Supraleiterschicht eines zweiten HTS-Bandleiters verbindet; und
- Fig. 9: die Fig. 8 nach Aufbringen einer durchgängigen vollflächigen Stabilisierungsschicht um das HTS-Bandleitersystem der Fig. veranschaulicht.

### 5. Detaillierte Beschreibung bevorzugter Ausführungsbeispiele

Im Folgenden werden bevorzugte Ausführungsbeispiele und ergänzende Beispiele eines
Hochtemperatur-Supraleiter (HTS)-Bandleitersystems und eines Verfahrens zu dessen Herstellung bzw. zur Reparatur eines HTS-Bandleiters anhand eines Beispiels erläutert. Es versteht sich, dass erfindungsgemäße HTS-Bandleitersysteme bzw. Verfahren zu deren Herstellung nicht auf die dargestellten Beispiele beschränkt, sondern durch die Ansprüche definiert sind.

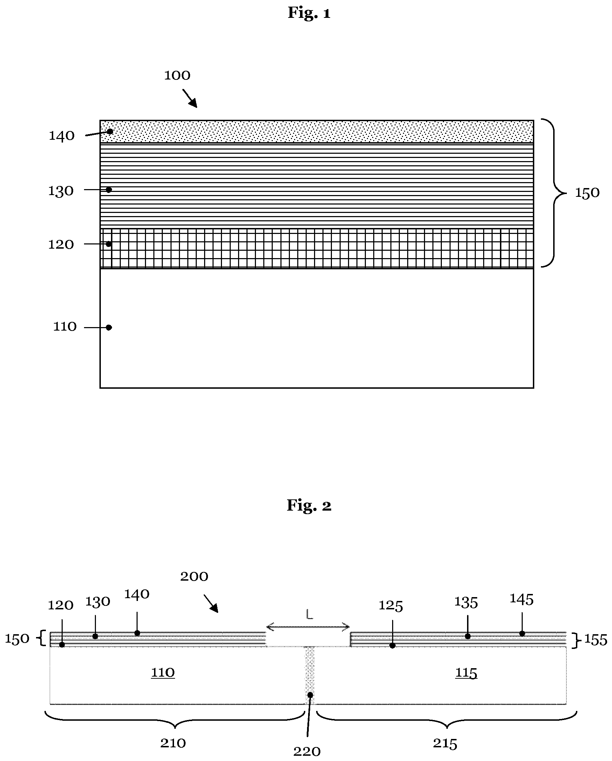

Der prinzipielle Aufbau eines nicht konfektionierten HTS-Bandleiters ist in der Fig. 1 schematisch dargestellt. Der Ausdruck "nicht konfektioniert" bedeutet in diesem Zusammenhang, dass es sich um eine Basisversion eines HTS-Bandleiters handelt, die sich in jedem konfektionierten, d.h. zum Einsatz vorbereiteten HTS-Bandleiter findet. Ein nicht konfektionierter HTS-Bandleiter oder eine Basisversion eines HTS-Bandleiters wird durch weitere Bearbeitungsschritte auf spezielle Anforderungen bzw. Einsatzzwecke angepasst. Dazu gehören u.a. das Schneiden oder das Längsteilen auf eine bestimmte Breite, sowie weitere Beschichtungen oder Umhüllungen zur elektrischen oder mechanischen Stabilisierung. Ferner umfassen die weiteren Bearbeitungsschritte zum Beispiel das Isolieren mit Lack, Kunststoff- oder Papierummantelungen.

Die Grundform oder Basisversion 100 eines HTS-Bandleiters umfasst eine dünne Metallfolie 110 als Substrat, die typischerweise mehr als 80 % der Gesamtdicke eines nicht konfektionierten HTS-Bandleiters ausmacht. Bei dem Metallsubstrat handelt es sich zumeist um Nickel (Ni)-oder Nickel-Chrom (NiCr)-Legierungen, Antikorrosivlegierungen wie Hastelloy™ C276 oder Hochtemperaturstähle. Die Dicke des Metallsubstrats 110 liegt typischerweise im Bereich von 50 µm - 200 µm.

Auf dem Metallsubstrat 110 werden vorzugsweise eine oder mehrere Pufferschichten 120 angeordnet, die u.a. als Diffusionsbarrieren, sowie zur Erzeugung bzw. zum Übertragen einer kristallinen Orientierung dienen.

Auf der bzw. den Pufferschichten 120 folgt die eigentliche HTS-Funktionsschicht 130, die in der Anwendung den Strom trägt und typischerweise eine Dicke von 0,5 µm - 10 µm aufweist. Bevorzugt liegt die HTS-Schichtdicke im Bereich von 1,5 µm - 5 µm. Die Zusammensetzung des Hochtemperatur-Supraleiters ist für das nachfolgend beschriebene Herstellen eines HTS-Bandleitersystems von untergeordneter Bedeutung. Es können deshalb HTS-Bandleiter aller gängigen Hochtemperatur-Supraleiter zu einem HTS-Bandleitersystem verspleißt werden.

Auf der HTS-Beschichtung 130 befindet sich eine dünne Kontaktschicht 140 aus einem Edelmetall, die einen möglichst geringen Kontaktwiderstand zum Supraleiter besitzt und der Stromeinspeisung in die HTS-Schicht 130 dient. Bevorzugt kommen für die Kontaktschicht 140 Silber- oder Silberlegierungen (z.B. mit Gold (Au) und/oder Kupfer (Cu) Anteilen) mit einer Schichtdicke von 0,1 µm - 5 µm zum Einsatz. Bevorzugt liegt die Metallschichtdicke der Kontaktschicht 140 im Bereich von 0,5 µm - 3 µm, um eine geschlossene Bedeckung und eine gute Lötbarkeit der Supraleiterschicht 130 zu gewährleisten. Die Gesamtdicke der Beschichtungen 120, 30 und 140 oder die HTS-Schichtfolge 150 liegt typischerweise im Bereich von 3 µm - 10 µm und ist damit gering im Vergleich zur Dicke des Metallsubstrats 110.

Wie bereits oben angesprochen, muss für viele Anwendungen die Basisversion 100 eines HTS-Bandleiters mit zusätzlichen Schichten oder Ummantelungen zur elektrischen oder mechanischen Stabilisierung verstärkt bzw. geschützt werden. Dies kann z.B. durch galvanisches Abscheiden von Kupfer oder anderen Metallen oder durch Laminieren mit weiteren Metallfolien, wie z.B. Kupfer, Messing oder Edelstahl geschehen. Da diese Schichten - die im Folgenden Stabilisierungsschichten genannt werden - nicht zum supraleitenden Stromfluss beitragen, reduzieren sie die effektive auf den Gesamtleiterquerschnitt bezogene technische Stromdichte. Häufig ist eine Stabilisierungsschicht jedoch notwendig, um den Supraleiter 130 bei kurzzeitiger Überlastung zu schützen. Die Dicke dieser Stabilisierungsschichten, die in der Fig. 1 nicht dargestellt sind, beträgt typischerweise 10 µm - 100 µm, bevorzugt 20 µm - 50 µm, und liegt damit bereits im Bereich der Substratdicke.

Werden HTS-Bandleitersysteme hergestellt, deren HTS-Bandleiter eine Stabilisierungsschicht aufweisen, kann die Stabilisierungsschicht im Bereich der Verbindung der HTS-Bandleiter abgetragen werden. Damit kann eine Reduzierung der Dicke der Verbindungsstelle erreicht werden; dies ist in der Patentschrift US 7 071 148 B1 beschrieben.

Für die Verarbeitung von HTS-Bandleitern zu einem HTS-Bandleitersystem ist es jedoch vorteilhaft, die Verbindung zur gewünschten Gesamtlänge des HTS-Bandleitersystems bereits in der Basisversion 100 des HTS-Bandleiters zu bewerkstelligen. Damit können alle nachgelagerten Arbeitsschritte, wie z.B. das Aufbringen einer Stabilisierungsschicht über die gesamte gewünschte Länge erfolgen. Dadurch können standardisierte Längen für HTS-Bandleitersysteme definiert werden.

Aus dem Stand der Technik ist jedoch keine Technik bekannt, die eine Verbindung der Basisformen 100 von HTS-Bandleitern erlaubt, bei der im Verbindungsbereich nicht durch die Überlappung zweier Enden der HTS-Bandleiter die doppelte Bandleiterdicke resultiert.

Das Diagramm 200 der Fig. 2 zeigt schematisch das mechanische Verbinden der Metallsubstrate 110 und 115 von einem ersten HTS-Bandleiter 210 und einem zweiten HTS-Bandleiter 215. Dazu werden die beiden HTS-Bandleiter 210 und 215 zueinander auf Stoß ausgerichtet, d.h. die Metallsubstrate 110 und 115 der beiden HTS-Bandleiter 210 und 215 bilden einen Stumpfstoß. Bevorzugt können dazu beide Bandleiter 210 und 215 in einer Vorrichtung so eingespannt werden, dass deren Kanten in Flucht und möglichst parallel zueinander verlaufen.

Das mechanische Verbinden der beiden Metallsubstrate 110 und 115 erfolgt bevorzugt durch Verschweißen der Enden der Metallsubstrate 110 und 115. Die Schweißstelle 220 oder allgemeiner der Metallsubstratverbindungsbereich 220 wird so behandelt, dass die Metallsubstrate 110 und 115 glatt ineinander übergehen und keine Verdickung auftritt. Zum Verschweißen können gängige Techniken eingesetzt werden. Bevorzugt wird zum kleinräumigen Schweißen der dünnen Metallsubstrate 110 und 115 ein Laserstrahl oder Elektronenstrahl verwendet.

In dem in der Fig. 2 dargestellten Beispiel sind die Metallsubstrate 110 und 115 im Wesentlichen gleich dick und weisen im Wesentlichen die gleiche Materialzusammensetzung auf. Dies sind jedoch keine Voraussetzungen für das Durchführen eines Stumpfstoß-Schweißprozesses.

In dem in der Fig. 2 gezeigten Beispiel ist die Schichtfolge 150 in einer Länge von L/2 von den Enden der Metallsubstrate 110 und 115 vor dem Schweißvorgang entfernt worden. Dies ist jedoch nicht notwendig. Allerdings werden aufgrund der starken thermischen Belastung während des Schweißvorgangs die Beschichtung 150 und 155 im Bereich einiger Millimeter um die Schweißstelle 220 herum zerstört. Die Ausdehnung der beim Schweißen zerstörten Region kann bei Bedarf durch aktives Kühlen der HTS-Bandleiter 210 und 210 begrenzt werden. Bevorzugt beträgt die laterale Ausdehnung L des Bereichs mit zerstörter Beschichtung um die Verbindungsstelle 220 weniger als 50 mm. Bevorzugt ist der geschädigte Bereich L auf weniger als 10 mm begrenzt.

Durch das mechanische Verbinden der Metallsubstrate 110 und 115 der Basisversion 100 zweier HTS-Bandleiter 210 und 215 wird die mechanische Verbindung des HTS-Bandleitersystems unabhängig von der elektrischen Verbindung der Supraleiter 130 und 135 der HTS-Bandleiter 210 und 215. Zur Herstellung einer elektrischen Verbindung, die nun keine mechanischen Zugkräfte mehr aufnehmen muss, kann eine sehr dünne, nahezu freistehende HTS-Schicht ohne dickes Substrat 110 oder Stabilisierungsschicht verwendet werden. Ein dünnes supraleitendes Verbindungsstück wird im Folgenden auch als HTS-Patch bezeichnet.

Zur Überbrückung der Verbindungstelle 220 sollte ein supraleitendes Verbindungsstück oder ein HTS-Patch die gesamte Breite der Metallsubstratbänder 110 und 115 abdecken und so lang sein, dass beiderseits der Verbindungsstelle 220 oder des Metallsubsubstratverbindungsbereichs 220 ein ausreichend großer Überlappungsbereich mit der unversehrten HTS-Bandleiterbeschichtung 150, 155 ermöglicht wird, in dem die elektrische Kontaktierung erfolgen kann. Bevorzugt ist ein supraleitendes Verbindungsstück oder ein HTS-Patch deshalb mindestens 30 mm lang.

HTS-Patches mit solchen Mindestlängen lassen sich dadurch erzeugen, dass von HTS-Bandleitern 100 Stücke mit entsprechender Länge abgeschnitten werden. Sodann wird im zweiten Schritt der Stapel der gesamten Bandleiterbeschichtung 150 an der Grenzfläche zum Metallsubstrat 110 großflächig abgelöst. Da die Haftung zwischen der Beschichtung 150 und dem Substrat 110 normalerweise sehr gut ist, müssen dafür besondere Verfahren zur Ablösung verwendet werden. Beispielhaft werden nachfolgend kurz zwei mögliche Verfahren beschrieben.

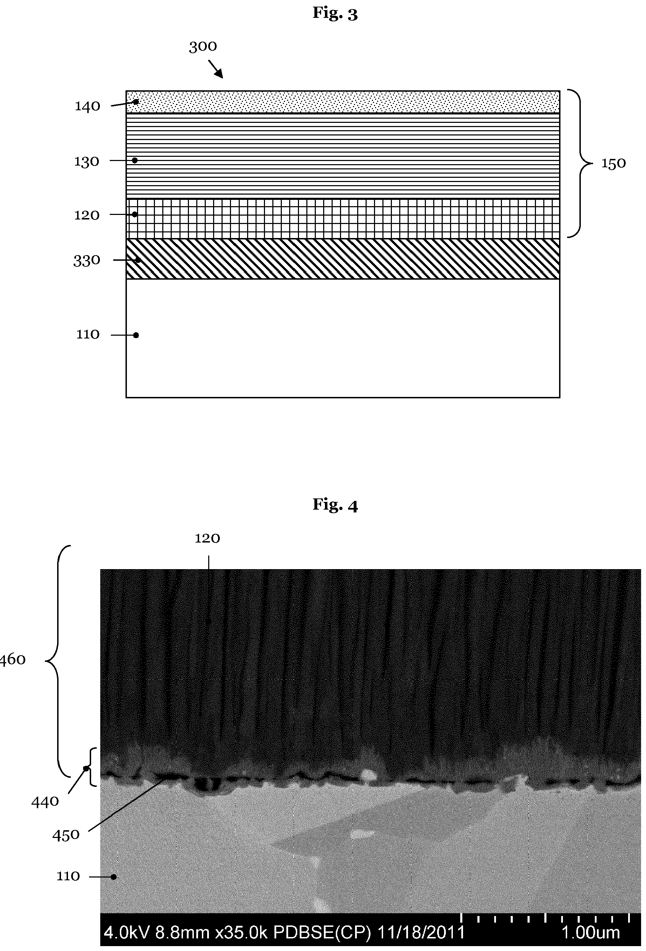

Eine erste Möglichkeit besteht darin, vor der Bandleiterbeschichtung 150, die eine Pufferschicht 120, eine HTS-Schicht 130 und eine Kontaktschicht 140 umfasst, zusätzlich eine Schicht auf des Metallsubstrat 110 aufzubringen, die nach der Fertigstellung der Bandleiterbeschichtung 150 (Basisversion) durch geeignete Lösungsmittel aufgelöst und entfernt werden kann. Die Fig. 3 zeigt einen HTS-Bandleiter 300 mit einer Opferschicht 330 zwischen dem Metallsubstrat 110 und der bzw. den Pufferschicht(en) 120.

Bei der Materialwahl dieser Opferschicht 330 ist darauf zu achten, dass diese kompatibel mit den Prozessbedingungen während der folgenden Beschichtungen ist. Insbesondere muss sie verträglich sein mit den hohen Abscheidetemperaturen für die HTS-Schicht 130, die über einer Temperatur von 650° C liegen. Deshalb kommt für die Opferschicht 330 vorzugsweise anorganisches Material in Frage. Da die HTS-Schicht 130 und auch einige Pufferschichtmaterialien zudem sehr empfindlich auf die Einwirkung von sauren Medien reagieren, muss der ph-Wert des Lösungsmittels größer als 6-7 sein, also im neutralen oder im basischen Bereich liegen. Das Patent EP 0 496 215 B1 beschreibt geeignete Opferschichtmaterialien im Zusammenhang mit der Herstellung von HTS-Schichten. Insbesondere eignen sich bevorzugt Calciumoxid (CaO) und Strontiumoxid (SrO). Auf diesen Schichten können durch gängige Bandleiterbeschichtungstechniken wie etwa "inclined substrate deposition" (ISD) oder "ion beam assisted deposition" (IBAD) hochwertige HTS-Bandleiterbeschichtungen 150 mit Stromtragfähigkeiten der HTS-Schicht 130 von > 10⁶ A/cm² hergestellt werden.

Diese Opferschichten 330 können beispielsweise durch die Einwirkung von Wasser gelöst werden, so dass die HTS-Beschichtung 150 auf dem Wasser aufschwimmt. Zudem reagieren die obigen Materialien bei ihrer Auflösung basisch und erhöhen somit natürlicherweise den ph-Wert des Lösungsmittels.

Die zweite Variante besteht darin, die Haftfestigkeit der normalen Bandleiterbeschichtung 150 (d.h. ohne Opferschicht 330) nach deren Herstellung gezielt zu schwächen. Typischerweise besteht eine der Pufferschichten 120 aus Magnesiumoxid (MgO). Dieses Material neigt bei hohen Temperaturen bei Kontakt mit Metallen wie Chrom zur Spinellbildung. Chrom ist ein gängiger Legierungsbestandteil der meisten für die HTS-Bandleiterfertigung verwendeten Metallsubstrate 110. In diesen Fällen genügt es deshalb durch Auslagerung des HTS-Bandleiters 100 bei Temperaturen > 600° C unter Sauerstoff oder Luft für mindestens 30 Minuten durch Diffusion von Substratbestandteilen und durch Reaktion mit der MgO-Schicht der Pufferschicht 130, dem Metallsubstrat 110 an der Grenzfläche zur Pufferschicht 120 Material zu entziehen. Dadurch entstehen an der Grenzfläche zwischen dem Metallsubstrat 110 und der Pufferschicht 120 ausgedehnte Hohlräume, die die Haftung der Beschichtung 150 massiv verringern. Die Beschichtung 150 kann dann sehr einfach z.B. mit Hilfe einer Klebefolie vom Metallsubstrat 110 abgezogen und übertragen werden.

Die Fig. 4 zeigt die Hohlraumbildung sehr eindrucksvoll anhand einer Querschnittspräparation im Elektronenmikroskop. Deutlich zu sehen ist dort an der Grenzfläche zwischen MgO-Pufferschicht 120 (dunkel) und Metallsubstrat 110 (hell) die etwas hellere, irregulär berandete Diffusionszone 440 in die MgO-Schicht hinein und die resultierenden Hohlräume 450 (schwarz) entlang der Grenzfläche. Derartige Beschichtungen 460 lösen sich praktisch ohne weiteres Zutun von selbst vom Substrat 110 ab und können weiterverarbeitet werden.

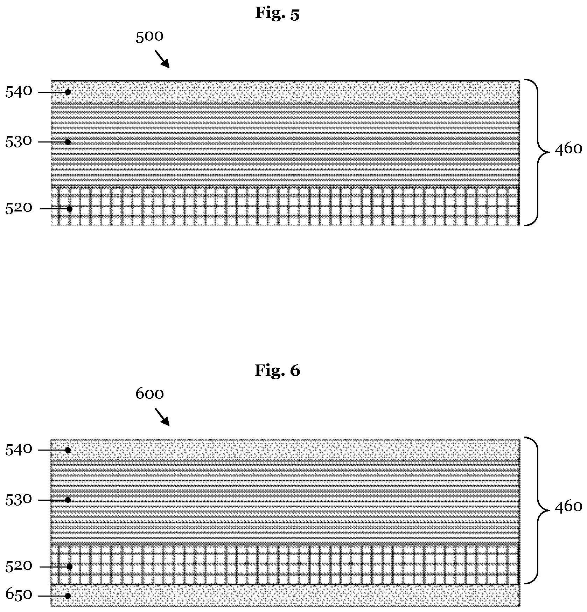

Das Diagramm 500 der Fig. 5 zeigt schematisch die abgelöste Beschichtung 460 mit der Pufferschicht 520, der HTS-Schicht 530 und der Kontaktschicht 540. Die Beschichtung 460 kann mit der Schichtenfolge 150 der Fig. 1 identisch sein, muss es aber nicht.

Zur Herstellung eines supraleitenden Verbindungsstücks oder eines HTS-Patches zum Überbrücken defekter HTS-Bandleiterabschnitte wird nach Ablösung der Beschichtung 460 deren Rückseite, d.h. die ehemalige Grenzfläche zum Metallsubstrat 110, ebenfalls mit einer metallischen Kontaktschicht 650 versehen. Die Fig. 6 zeigt schematisch ein supraleitendes Verbindungsstück 600. Vorzugsweise wird für die Kontaktschicht 650 dasselbe oder ein sehr ähnliches Edelmetall wie für die Kontaktschicht 140 bzw. 540 verwendet. Ferner ist es bevorzugt, die metallische Beschichtung 650 ebenfalls auf die Seitenflächen an den Rändern des supraleitenden Verbindungsstücks 600 zu erstrecken, so dass das supraleitende Verbindungsstück ganzflächig von einer leitfähigen Schicht überzogen ist. Die Belegung der Seitenflächen mit einer Beschichtung ist in der Fig. 6 nicht dargestellt.

Der HTS-Patch 600 kann in dieser Form zur elektrischen Überbrückung sowie zur Verstärkung und zur Reparatur von Schwachstellen und Defekten in einer HTS-Bandleiterbeschichtung 150 und an Verbindungsstellen 220 eingesetzt werden.

Damit ein supraleitendes Verbindungsstück 600 oder ein HTS-Patch eine effektive elektrische Verbindung oder Überbrückung darstellt, muss seine Kontaktschicht 650 leitfähig mit den Kontaktschichten 140 und 145 der HTS-Bandleiter 210 und 215 verbunden werden. Der Kontaktwiderstand sollte dabei unterhalb 1 µΩcm² liegen, um bei Normalbelastung eine hohe Verlustleistung im Kontaktbereich zu vermeiden. Solche Kontakte werden durch Bonden oder Löten der beiden Kontakt- oder Silberschichten 140 und 650 bzw. 145 und 650 erreicht. Beim Bonden werden die Silberschichten 140 und 650 bzw. 145 und 650 aufeinandergepresst und kalt verschweißt. Dies kann durch die Einwirkung von Ultraschall und/oder von Wärme unterstützt werden. Die Temperatur darf jedoch 450° C nicht überschreiten, um eine Degradation der HTS-Schichten 130, 135 und 530 durch Phasenumwandlung und Sauerstoffverlust zu vermeiden.

Zum Löten kann eine Schicht niedrigschmelzenden Metalls eingesetzte werden. Bevorzugt sollte die Schmelztemperatur zum Löten unterhalb von 250° C liegen, so dass Legierungen der Metalle Indium (In), Zinn (Sn), Wismut (Bi) oder Blei (Pb) zum Einsatz kommen können. Um die Löslichkeit der dünnen Edelmetallkontaktschichten 140, 145 und 650 in der Lotschmelze zu reduzieren, enthält das Lot bevorzugt auch einen Anteil dieses Edelmetalls als Legierungszusatz. So kann zum Beispiel als Lot Indium mit einem Zusatz von 3 Gewichts-% Silber (Ag) zum Löten von Silberschichten verwendet werden.

Im Folgenden werden einige bevorzugte Ausführungsformen bzw. Ausführungsbeispiele supraleitender Überbrückungen beschrieben:

### Beispiel 1:

Bei dem ersten dargestellten Beispiel, das ergänzend ist und außerhalb der beanspruchten Erfindung liegt, handelt es sich um die Reparatur bzw. Verstärkung der Basisversion 100 eines HTS-Bandleiters mit einer lokalen Schwachstelle, an der die kritische Stromtragfähigkeit in der HTS-Schicht 130 um mindestens 10 %, in Fällen starker Degradation um mehr als 20 % und in besonders starken Fällen um mehr als 40 % reduziert ist. Die Stromtragfähigkeit und damit die Dicke der HTS-Schicht 530 im HTS-Patch 600 wird so gewählt, dass die Degradation ausgeglichen oder überkompensiert werden kann, so dass die Stromtragfähigkeit an der verstärkten Stelle nicht geringer ist, als die mittlere Stromtragfähigkeit im übrigen HTS-Bandleiter 100. Bei vergleichbarer Stromtragfähigkeit der HTS-Schicht 530 im supraleitenden Verbindungsstück 600 und defektfreiem HTS-Bandleiter 600 sollte die Dicke der HTS-Schicht 530 im HTS-Patch 600 deshalb in den oben beschriebenen Fällen entsprechend der Degradation mindestens 10 %, mindestens 20 % oder mindestens 40 % der HTS-Schichtdicke 130 des HTS-Bandleiters 100 betragen.

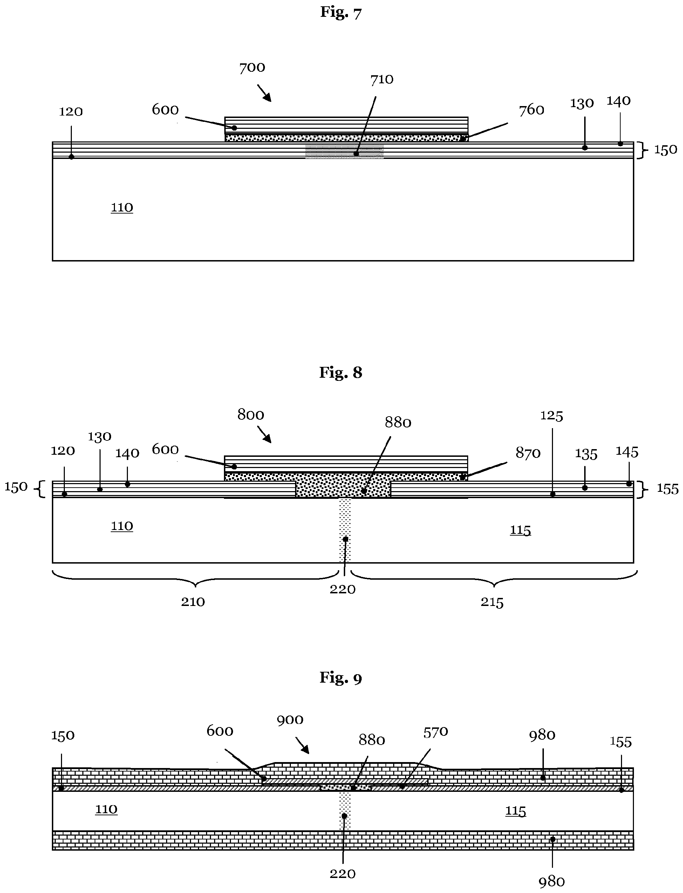

Die Fig. 7 zeigt beispielhaft diese Ausführungsform. Der HTS-Bandleiter 700, der im Aufbau identisch mit dem in der Fig. 1 dargestellten Bandleiter 100 ist, weist im grau hinterlegten Bereich eine Defektstelle 710 mit reduzierter kritischer Stromtragfähigkeit auf. Diese wird mit einem aufgelöteten HTS-Patch 600, dessen Aufbau schematisch in der Fig. 6 dargestellt ist, überbrückt. Das supraleitende Verbindungsstück 600 ist an seiner HTS-seitigen Kontaktschicht 650 über eine dünne Lotschicht 760 mit der Kontaktschicht 140 des HTS-Bandleiters 700 verbunden. Um die Dicke der verstärkten Stelle so gering wie möglich zu halten, sollte die Lotschicht 760 nicht dicker als 20 % der Bandleiterdicke sein. Bevorzugt beträgt die Dicke der Lotschicht 760 nicht mehr als 10 µm, besonders bevorzugt nicht mehr als 5 µm.

### Beispiel 2:

Die erste bevorzugte Ausführungsform der Erfindung ist in Fig. 8 dargestellt. Es handelt sich um die Verbindungsstelle 220 zweier HTS-Bandleiter 210 und 215, die an der Stoßstelle 220 (grau) verschweißt wurden. Der HTS-Patch 600 überbrückt die Verbindungsstelle 220 in der die HTS-Schichten 130 und 135 der HTS-Bandleiter 210, 210 unterbrochen sind. Das supraleitende Verbindungsstück 600 wird über eine dünne Lotschicht 870 auf beiden Seiten der Verbindung elektrisch leitfähig mit den HTS-Schichten 130, 135 der beiden HTS-Bandleiter 210, 215 verbunden. Der Bereich 880 um die Verbindungsstelle 220 in dem die Beschichtungen 150, 155 von den HTS-Bandleitern 210, 215 entfernt wurde, ist ebenfalls mit Lotmaterial gefüllt. Wie bereits erwähnt, ist es nicht notwendig, die Beschichtung 150, 55 im Bereich der Verbindungsstelle 220 vor dem Verbinden der Metallsubstrate 110, 115 zu entfernern. Ferner ist es ebenfalls nicht notwendig, während des Schweißprozesses beschädigte Bereich der Beschichtung 150, 55 vor dem Anbringen eines HTS-Patches 600 zu entfernen. Die Stromtragfähigkeit der HTS-Schicht 530 im HTS-Patch 600 ist so gewählt, dass sie der mittleren Stromtragfähigkeit der HTS-Bandleiter 210 und 215 entspricht oder darüber liegt. Dies bedeutet, die Dicke HTS-Schicht 530 eines supraleitenden Verbindungsstücks 600 kann an die jeweilige Anwendung angepasst werden, um die jeweils geforderte Stromtragfähigkeit zu gewährleisten.

Auch bei dieser Anordnung wird darauf geachtet, die Dicke der Verbindungstelle 220 so gering wie möglich zu halten. Deshalb sollte die Lotschicht 870 nicht dicker als 20 % der Bandleiterdicke sein. Bevorzugt beträgt die Dicke der Lotschicht 870 nicht mehr als 10 µm, besonders bevorzugt nicht mehr als 5 µm.

### Beispiel 3:

In einer zweiten bevorzugten Ausführungsform der Erfindung wird das Lot in den Beispielen 1 und 2 durch einen elektrisch sehr gut leitfähigen Kleber ersetzt. Dabei kann es sich zum Beispiel um Epoxidharzkleber mit einer Füllung mikroskopischer oder nanoskopischer Silberpartikel handeln. Neben einer geringen Verdickung des Verbindungsbereichs sollte der Kleber auch aus Gründen optimaler Leitfähigkeit sehr dünn aufgetragen werden und bevorzugt nicht dicker als 10 µm, besonders bevorzugt nicht dicker als 5 µm sein.

### Beispiel 4:

Um den Materialauftrag durch Lot oder Kleber komplett zu umgehen, besteht auch die Möglichkeit das supraleitende Verbindungsstück 600 in den Beispielen 1 bis 3 mittels einer Bondverbindung über die Kontaktschichten 140 und 650 bzw. 145 und 650 zu verbinden. Dazu wird im Überlappungsbereich vom HTS-Bandleiter 210 (215) und dem supraleitenden Verbindungsstück 600 die Kontaktschicht 650 des supraleitenden Verbindungsstücks 600 auf die Kontaktschichten 140 bzw. 145 gepresst und durch homogene Druckausübung und ggf. unter Einwirkung von Wärme und Ultraschall eine kalt verschweißte innige Metallverbindung erzeugt.

### Beispiel 5:

Nach dem Verbinden von HTS-Bandleitern zu einem HTS-Bandleitersystem bzw. nach einer Reparatur eines HTS-Bandleiters kann - wie oben beschrieben - das hergestellte HTS-Bandleitersystem 800 bzw. der reparierte HTS-Bandleiter 700 in einem Stück durchgängig mit zusätzlichen Schichten zur Verstärkung oder zur elektrischen Isolierung ummantelt werden. Ein besonders wichtiges Verfahren ist dabei die galvanische Ummantelung des gesamten HTS-Bandleitersystems 800 oder des HTS-Bandleiters 700 (z.B. mit einer Kupferhülle) zur elektrischen Stabilisierung gegen kurzzeitige Stromüberlastung.

Da das supraleitfähige Verbindungsstück 600 komplett mit leitfähigen Schichten umhüllt ist, kann der damit verstärkte HTS-Bandleiter 700 oder das HTS-Bandleitersystem 800 wie ein einzelner HTS-Bandleiter prozessiert und beispielsweise durch ein Galvanikbad gezogen werden. Dadurch wird auch die Verbindungstelle 220 oder die verstärkte Stelle 710 kontinuierlich d.h. ohne Bruch- oder Stoßstelle in der Hülle 980 ummantelt, so dass die Verbindungsstelle 220 und die verstärkte Stelle 710 nachträglich kaum noch sichtbar sind oder auftragen. Das Ergebnis - ein stabilisierter, rundum hermetisch geschlossenes HTS-Bandleitersystem 900 mit innenliegender Verbindungsstelle 220 ist beispielhaft in der Fig. 9 skizziert. Dadurch ist eine deutlich bessere und einfachere Verarbeitung des umhüllten HTS-Bandleitersystems 900 bzw. HTS-Bandleiters, z.B. beim Wickeln von Spulen oder beim Verseilen zu Kabeln gewährleistet.

## Patentansprüche

1. Hochtemperatur-Supraleiter-Bandleitersystem (800, 900) aufweisend:
a. einen ersten Hochtemperatur-Supraleiter-Bandleiter (210) mit einem ersten Metallsubstrat (110) und einer ersten Supraleiterschicht (130);
b. einen zweiten Hochtemperatur-Supraleiter-Bandleiter (215) mit einem zweiten Metallsubstrat (115) und einer zweiten Supraleiterschicht (135); und
c. einen Metallsubstratverbindungsbereich (220), in dem das erste und das zweite Metallsubstrat im Wesentlichen auf Stoß miteinander verbunden sind, wobei der Metallverbindungsbereich ausgebildet ist, um einer Zugspannung von mehr als 50 % der Zugspannung zu widerstehen, der das erste oder das zweite Metallsubstrat ohne wesentliche Beschädigung widersteht;
weiterhin aufweisend ein Verbindungsstück (600) zum Herstellen einer supraleitenden Verbindung zwischen der ersten Supraleiterschicht und der zweiten Supraleiterschicht, das Verbindungsstück aufweisend:
d. zumindest eine Pufferschicht;
e. eine erste Kontaktschicht, die auf einer ersten Seite der Pufferschicht nach Ablösen eines Metallsubstrats angeordnet ist;
f. eine Supraleiterschicht, die auf einer zweiten Seite der Pufferschicht angeordnet ist; und
g. eine zweite Kontaktschicht, die auf der Supraleiterschicht angeordnet ist.

2. Hochtemperatur-Supraleiter-Bandleitersystem nach Anspruch 1, wobei das erste und das zweite Metallsubstrat durch Schweißen miteinander verbunden sind, insbesondere durch Elektronenstrahl-Schweißen oder Laserstrahl-Schweißen.

3. Hochtemperatur-Supraleiter-Bandleitersystem nach Anspruch 1 oder 2, wobei der Metallsubstratverbindungsbereich eine Dicke von weniger als 1,5 der mittleren Dicke des ersten und des zweiten Metallsubstrats, bevorzugt weniger als 1,3 der mittleren Dicke des ersten und des zweiten Metallsubstrats, mehr bevorzugt weniger als 1,2 der mittleren Dicke des ersten und des zweiten Metallsubstrats und am meisten bevorzugt weniger als 1,1 der mittleren Dicke des ersten und des zweiten Metallsubstrats aufweist.

4. Hochtemperatur-Supraleiter-Bandleitersystem nach einem der vorhergehenden Ansprüche, wobei der Metallverbindungsbereich ausgebildet ist, um einer Zugspannung von mehr als 60 %, bevorzugt mehr als 70 %, und am meisten bevorzugt mehr als 80 % der Zugspannung zu widerstehen, der das erste oder das zweite Metallsubstrat ohne wesentliche Beschädigung widersteht.

5. Verfahren zum Herstellen eines Hochtemperatur-Supraleiter-Bandleitersystems (800, 900), das Verfahren die Schritte aufweisend:
a. Ausrichten eines ersten Hochtemperatur-Supraleiter-Bandleiters (210) mit einem ersten Metallsubstrat (110) und einer ersten Supraleiterschicht (130) und eines zweiten Hochtemperatur-Supraleiter-Bandleiters (215) mit einem zweiten Metallsubstrat (115) und einer zweiten Supraleiterschicht (135) im Wesentlichen auf Stoß;
b. Verbinden des ersten und des zweiten Metallsubstrats in einem Metallsubstratverbindungsbereich (220), in dem das erste und das zweite Metallsubstrat im Wesentlichen auf Stoß miteinander verbunden sind, wobei der Metallverbindungsbereich ausgebildet ist, um einer Zugspannung von mehr als 50 % der Zugspannung zu widerstehen, der das erste oder das zweite Metallsubstrat ohne wesentliche Beschädigung widersteht;
c. Anbringen eines supraleitenden Verbindungsstücks (600) auf die erste und die zweite Supraleiterschicht, wobei das supraleitende Verbindungsstück aufweist:
(i) zumindest eine Pufferschicht;
(ii) eine erste Kontaktschicht, die auf einer ersten Seite der Pufferschicht nach Ablösen eines Metallsubstrats angeordnet ist;
(iii) eine Supraleiterschicht, die auf einer zweiten Seite der Pufferschicht angeordnet ist; und
(iv) eine zweite Kontaktschicht, die auf der Supraleiterschicht angeordnet ist.

6. Verfahren nach Anspruch 5, wobei das Verbinden des ersten und des zweiten Metallsubstrats das Schweißen auf Stumpfstoß des ersten und des zweiten Metallsubstrats umfasst.

7. Verfahren nach Anspruch 5 oder 6, wobei weder der erste Hochtemperatur-Supraleiter-Bandleiter noch der zweite Hochtemperatur-Supraleiter-Bandleiter eine Stabilisierungsschicht aufweist.

8. Verfahren nach Anspruch 5, wobei das Herstellen des supraleitenden Verbindungsstücks die Schritte umfasst:
a. Schneiden eines Hochtemperatur-Supraleiter-Bandleiters auf eine vorgegebene Länge, wobei der Hochtemperatur-Supraleiter-Bandleiter umfasst: ein Metallsubstrat, zumindest eine Pufferschicht, die auf dem Metallsubstrat angeordnet ist, und eine Supraleiterschicht, die auf der zumindest einen Pufferschicht angeordnet ist; und
b. Ablösen eines Metallsubstrats von dem Hochtemperatur-Supraleiter-Bandleiter.

9. Verfahren nach Anspruch 8, wobei das Ablösen des Metallsubstrats umfasst:
c. Ändern der chemischen Zusammensetzung der zumindest einen Pufferschicht; und
d. Abheben der geänderten Pufferschicht und der Supraleiterschicht von dem Metallsubstrat.

10. Verfahren nach Anspruch 8 oder 9, wobei der Schritt c. ferner aufweist: Auslagern des Hochtemperatur-Supraleiter-Bandleiters bei einer Temperatur größer als 600° C in Sauerstoff und/oder in Luft für eine vorgegebene Zeitdauer, bevorzugt für mehr als 30 Minuten.

11. Verfahren nach einem der Ansprüche 8 - 10, ferner den Schritt aufweisend: Anbringen einer Kontaktschicht auf eine von der Supraleiterschicht abgewandte Seite der Pufferschicht.

12. Verfahren nach Anspruch 5, ferner den Schritt aufweisend: Aufbringen einer durchgängigen Stabilisierungsschicht auf die erste Supraleiterschicht, das Verbindungsstück und die zweite Supraleiterschicht.

13. Verfahren nach einem der Ansprüche 5 - 12, ferner den Schritt aufweisend: Aufbringen einer durchgängigen Stabilisierungsschicht auf das erste Metallsubstrat, den Metallsubstratverbindungsbereich und das zweite Metallsubstrat.

## Claims

1. A high temperature superconductor tape system (800, 900), comprising:
a. a first high temperature superconductor tape (210) having a first metal substrate (110) and a first superconducting layer (130);
b. a second high temperature superconductor tape (215) having a second metal substrate (115) and a second superconducting layer (135);
c. a metal substrate connecting area (220) in which the first and the second metal substrate are essentially connected edge to edge with each other, wherein the metal substrate connecting area (220) is configured to resist a tensile stress of more than 50% of that tensile stress to which the first and the second metal substrate essentially resist without damage;
further comprising a connecting piece (600) for manufacturing a superconducting connection between the first superconducting layer and the second superconducting layer, the connection piece comprising:
d. at least one buffer layer;
e. a first contact layer which is arranged on a first side of the buffer layer after removing a metal substrate;
f. a superconducting layer which is arranged on a second side of the buffer layer; and
g. a second contact layer which is arranged on the superconducting layer.

2. The high temperature superconductor tape system of claim 1, wherein the first and the second metal substrate are connected with each other by welding, in particular by electron beam welding or laser beam welding.

3. The high temperature superconductor tape system of claim 1 or 2, wherein the metal substrate connecting area has a thickness of less than 1.5 of the average thickness of the first and the second metal substrate, preferably less than 1.3 of the average thickness of the first and the second metal substrate, more preferably less than 1.2 of the average thickness of the first and the second metal substrate, and most preferably less than 1.1 of the average thickness of the first and the second metal substrate.

4. The high temperature superconductor tape system of one of the preceding claims, wherein the metal substrate connecting area is configured to resist a tensile stress of more than 60%, preferably more than 70%, and most preferred more than 80% of the tensile stress to which the first and second metal substrate essentially resists without damage.

5. A method for manufacturing a high temperature superconductor tape system (800, 900), the method comprising the steps:
a. aligning a first high temperature superconductor tape (210) having a first metal substrate (110) and a first superconducting layer (130) and a second high temperature superconductor tape (215) having a second metal substrate (115) and a second superconducting layer (135) essentially edge to edge;
b. connecting the first and the second metal substrate in a metal substrate connecting area (220) by connecting the first and the second metal substrate essentially edge to edge with each other, wherein the metal substrate connecting area (220) is configured to resist a tensile stress of more than 50% of the tensile stress to which the first and the second metal substrate essentially resist without damage;
c. affixing a superconducting connecting piece (600) on the first and the second superconducting layer, wherein the superconducting connecting piece comprises:
(i) at least one buffer layer;
(ii) a first contact layer which is arranged on a first side of the buffer layer after removing a metal substrate;
(iii) a superconducting layer which is arranged on a second side of the buffer layer; and
(iv) a second contact layer which is arranged on the superconducting layer.

6. The method of claim 5, wherein connecting the first and the second metal substrate comprises butt joint welding of the first and the second metal substrate.

7. The method of claim 5 or 6, wherein neither the first high temperature superconductor tape nor the second high temperature superconductor tape has a stabilization layer.

8. The method of claim 5, wherein manufacturing the superconducting connecting piece comprises the steps:
a. cutting a high temperature superconductor tape to a predetermined length, wherein the high temperature superconductor tape comprises: a metal substrate, at least one buffer layer which is arranged on the metal substrate, and a superconducting layer which is arranged on the at least one buffer layer; and
b. removing a metal substrate from the high temperature superconductor tape.

9. The method of claim 8, wherein removing the metal substrate comprises:
c. changing the chemical composition of the at least one buffer layer; and
d. lifting off the changed buffer layer and the high temperature superconducting layer from the metal substrate.

10. The method of claim 8 or 9, wherein step c. further comprises: aging the high temperature superconductor tape in an oxygen atmosphere at a temperature larger than 600 °C and / or in an ambient atmosphere for a predetermined time period, preferably more than 30 minutes.

11. The method of one of claims 8 - 10, further comprising the step: affixing a contact layer on the side of the superconducting layer which is opposite to the buffer layer.

12. The method of claim 5, further comprising the step: arranging a continuous stabilization layer on the first superconducting layer, the connecting piece and the second superconducting layer.

13. The method of claim 5 or 6, further comprising the step: arranging a continuous stabilization layer on the first superconducting layer, the metal substrate connecting area and the second metal substrate.

## Revendications

1. Système de rubans supraconducteurs à haute température (800, 900) comprenant :
a. un premier ruban supraconducteur à haute température (210) avec
un premier substrat métallique (110)
et une première couche supraconductrice (130) ;
b. un deuxième ruban supraconducteur à haute température (215) avec
un deuxième substrat métallique (115)
et une deuxième couche supraconductrice (135) ; et
c. une zone de liaison de substrats métalliques (220) dans laquelle le premier et le deuxième substrat métallique sont reliés ensemble sensiblement bout à bout, la zone de liaison métallique étant conçue pour résister à une contrainte de traction supérieure à 50 % de la contrainte de traction à laquelle le premier ou le deuxième substrat métallique résiste sans endommagement sensible ;
et comprenant en outre une pièce de liaison (600) pour établir une liaison supraconductrice entre la première couche supraconductrice et la deuxième couche supraconductrice, la pièce de liaison comprenant :
d. au moins une couche tampon ;
e. une première couche de contact qui est disposée sur un premier côté de la couche tampon après détachement d'un substrat métallique ;
f. une couche supraconductrice qui est disposée sur un deuxième côté de la couche tampon ; et
g. une deuxième couche de contact qui est disposée sur la couche supraconductrice.

2. Système de rubans supraconducteurs à haute température selon la revendication 1, dans lequel le premier et le deuxième substrat métallique sont reliés ensemble par soudage, en particulier par soudage par faisceau d'électrons ou soudage par faisceau laser.

3. Système de rubans supraconducteurs à haute température selon la revendication 1 ou 2, dans lequel la zone de liaison de substrats métalliques présente une épaisseur inférieure à 1,5 fois l'épaisseur moyenne du premier et du deuxième substrat métallique, de préférence inférieure à 1,3 fois l'épaisseur moyenne du premier et du deuxième substrat métallique, davantage de préférence inférieure à 1,2 fois l'épaisseur moyenne du premier et du deuxième substrat métallique et, le plus préférentiellement, inférieure à 1,1 fois l'épaisseur moyenne du premier et du deuxième substrat métallique.

4. Système de rubans supraconducteurs à haute température selon l'une des revendications précédentes, dans lequel la zone de liaison métallique est conçue pour résister à une contrainte de traction supérieure à 60 %, de préférence supérieure à 70 % et le plus préférentiellement supérieure à 80 % de la contrainte de traction à laquelle le premier ou le deuxième substrat métallique résiste sans endommagement sensible.

5. Procédé de fabrication d'un système de rubans supraconducteurs à haute température (800, 900), lequel procédé comprend les étapes suivantes :
a. alignement sensiblement bout à bout d'un premier ruban supraconducteur à haute température (210) avec un premier substrat métallique (110) et une première couche supraconductrice (130) et d'un deuxième ruban supraconducteur à haute température (215) avec un deuxième substrat métallique (115) et une deuxième couche supraconductrice (135) ;
b. liaison du premier et du deuxième substrat métallique dans une zone de liaison de substrats métalliques (220) dans laquelle le premier et le deuxième substrat métallique sont reliés ensemble sensiblement bout à bout, la zone de liaison métallique étant conçue pour résister à une contrainte de traction supérieure à 50 % de la contrainte de traction à laquelle le premier ou le deuxième substrat métallique résiste sans endommagement sensible ;
c. application d'une pièce de liaison supraconductrice (600) sur la première et la deuxième couche supraconductrice, la pièce de liaison supraconductrice comprenant :
(i) au moins une couche tampon ;
(ii) une première couche de contact qui est disposée sur un premier côté de la couche tampon après détachement d'un substrat métallique ;
(iii) une couche supraconductrice qui est disposée sur un deuxième côté de la couche tampon ; et
(iv) une deuxième couche de contact qui est disposée sur la couche supraconductrice.

6. Procédé selon la revendication 5, selon lequel la liaison du premier et du deuxième substrat métallique comprend le soudage bout à bout du premier et du deuxième substrat métallique.

7. Procédé selon la revendication 5 ou 6, selon lequel ni le premier ruban supraconducteur à haute température ni le deuxième ruban supraconducteur à haute température ne présentent une couche de stabilisation.

8. Procédé selon la revendication 5, selon lequel la fabrication de la pièce de liaison supraconductrice comprenant les étapes suivantes :
a. coupe d'un ruban supraconducteur à haute température à une longueur prédéfinie, le ruban supraconducteur à haute température comprenant : un substrat métallique, au moins une couche tampon qui est disposée sur le substrat métallique et une couche supraconductrice qui est disposée sur ladite au moins une couche tampon ; et
b. détachement d'un substrat métallique du ruban supraconducteur à haute température.

9. Procédé selon la revendication 8, selon lequel le détachement du substrat métallique comprend les étapes suivantes :
c. modification de la composition chimique de ladite au moins une couche tampon ; et
d. enlèvement de la couche tampon modifiée et de la couche supraconductrice du substrat métallique.

10. Procédé selon la revendication 8 ou 9, selon lequel l'étape c. comprend en outre l'étape suivante : exposition du ruban supraconducteur à haute température à l'oxygène et/ou à l'air à une température supérieure à 600 °C pendant une durée prédéfinie, de préférence supérieure à 30 minutes.

11. Procédé selon l'une des revendications 8 à 10, comprenant en outre l'étape suivante : application d'une couche de contact sur un côté de la couche tampon opposé à la couche supraconductrice.

12. Procédé selon la revendication 5, comprenant en outre l'étape suivante : application d'une couche continue de stabilisation sur la première couche supraconductrice, la pièce de liaison et la deuxième couche supraconductrice.

13. Procédé selon l'une des revendications 5 à 12, comprenant en outre l'étape suivante : application d'une couche continue de stabilisation sur le premier substrat métallique, la zone de liaison de substrats métalliques et le deuxième substrat métallique.
